# EUROPÄISCHE PATENTANMELDUNG

(11) **EP 0 759 636 A2**
(43) Veröffentlichungstag der Anmeldung: **26.02.1997**
(21) Anmeldenummer: 96810485.1
(22) Anmeldetag: 24.07.1996
(51) Int. Cl.: H01L 23/367

(54) **Kühlkörper für Halbleiterbauelemente oder dergleichen**

(30) Priorität: 17.08.1995 DE 29513283 U
(71) Anmelder: Alusuisse Technology & Management AG, 8212 Neuhausen am Rheinfall (CH)
(72) Erfinder: Bock, Uwe, 78224 Singen (DE)

(57) **Zusammenfassung**

Kühlkörper für Halbleiterbauelemente od. dgl. Geräte, insbesondere zumindest teilweise aus stranggepresstem Aluminium oder anderem Leichtmetall hergestellte Hochleistungskühleinheit mit in Abstand zueinander an einer Grundplatte angeschlossenen und davon aufragenden Kühlrippen, die jeweils als hohles Profil mit zwei seitlichen Rippenwänden ausgebildet sind, wobei die Kühlrippe in einer Längs-oder Einsatznut od.dgl. Ausnehmung der Grundplatte festliegt.

Die Kühlrippe (20, 20a) ist querschnittlich als U-Profil stranggepresst oder aus einem rollgeformten Band hergestellt, wobei die als freie Schenkel (22) ausgebildeten Rippenwände in den Längsnuten (14) der Grundplatte (12) unter Bildung einer Rückstellkraft klemmend gehalten sind.

## Beschreibung

Die Erfindung betrifft einen Kühlkörper für Halbleiterbauelemente od.dgl. Geräte -- insbesondere eine zumindest teilweise aus stranggepreßtem Aluminium oder anderem Leichtmetall hergestellte Hochleistungskühleinheit -- mit in Abstand zueinander an eine Grundplatte angeschlossenen und davon aufragenden Kühlrippen, die jeweils als hohles Profil mit zwei seitlichen Rippenwänden ausgebildet sind; jede Kühlrippe liegt in einer Längs- oder Einsatznut od.dgl. Ausnehmung der Grundplatte fest.

Die DE-PS 35 18 310 beschreibt einen Hochleistungskühlkörper, bei dem eine stranggepreßte Grundplatte mit gesondert stranggepreßten Rippen mittels eines speziellen Fügeverfahren formschlüssig verbunden werden. Die hierbei praktizierte Art der Verformung mit dem Ziel, einen optimalen Wärmeübergang zwischen Grundplatte und Kühlrippen zu schaffen, erfordert relativ hohe Kräfte mit entsprechendem maschinellem Aufwand.

Gegenüber der Lehre der DE-PS 35 18 310 stellt diese einen gattungsgemäßen Kühlkörper mit zwischen zwei -- mit der Grundplatte eine Art Rechteckrinne ergebenden -- Flankenwänden verlaufenden Kühlrippen nach der EP-A-0 483 058 der Anmelderin eine Verbesserung dar. Sowohl die Innenflächen der Flankenwände als auch die Außenflächen der Kühlrippen sind mit Riffelungen ausgestattet, die parallel zur Grundplatte verlaufen. Die beiden Rippenwände jeder Kühlrippe sind an einem Ende durch einen in der Einsatznut der Grundplatte festlegbaren Kupplungssockel und am anderen Ende durch einen Quersteg verbunden; ein weiterer Quersteg teilt den Rippenhohlraum etwa in halber Höhe in zwei Kanäle. Mit diesem Kühlkörper sollten sowohl die Wanddicken von Kühlrippen als auch der Herstellungsaufwand für den Kühlkörper vermindert werden. Es wurde ein Rippenverhältnis von etwa 30 : 1 erreicht.

Besonders bei Zwangsbelüftung mit Axiallüftern ergeben sich Bauformen relativ großer Rippenhöhe und geringer Rippendicke. Der Rippenwirkungsgrad ist damit relativ schlecht. Verfahrensbedingt ist der Abstand zwischen den einzelnen Kühlrippen mit mindestens 3 mm nach unten begrenzt.

Für den Einsatz bei erzwungener Konvektion mit hoher Luftgeschwindigkeit und entsprechend hoher Wärmeübergangszahl ist eine gute Verbindung zwischen Kühlrippe und Grund- oder Basisplatte unerläßlich; die große Wärmestromdichte würde sonst zu relativ hohen Temperaturdifferenzen in den Fügezonen führen und damit den Wirkungsgrad eines Kühlkörpers spürbar verschlechtern.

Es gibt jedoch auch Anwendungsfälle, die den oben erörterten Aufwand nicht unbedingt rechtfertigen. Dies gilt im besonderen für den Einsatz bei freier Konvektion und eingeschränkt auch für erzwungene Konvektion bei niedriger Luftgeschwindigkeit.

In Kenntnis dieses Standes der Technik hat sich der Erfinder die Aufgabe gestellt, einen Kühlkörper zu schaffen, der den Vorteil geringen Rippenabstandes sowie geringer Rippendicke -- und damit relativ hohe spezifische Kühlleistung -- bietet, aber gleichzeitig durch reduzierten Fertigungsaufwand kostengünstiger herzustellen ist.

Zur Lösung dieser Aufgabe führt die Lehre nach dem unabhängigen Anspruch; die Unteransprüche geben günstige Weiterbildungen an.

Erfindungsgemäß ist wenigstens ein Teil der Kühlrippen querschnittlich als U-Profile stranggepreßt oder aus einem rollgeformten Band hergestellt, wobei die als freie Schenkel ausgebildeten Rippenwände in den Längsnuten der Grundplatte unter Bildung einer Rückstellkraft klemmend gehalten sind. Hierzu verjüngt sich die Längsnut querschnittlich wenigstens teilweise, und die Nutenwände drücken im Bereich des engsten Abstandes gegen jene Schenkel.

Als günstig hat es sich zur Erzeugung jener Rückstellkraft erwiesen, daß sich der Abstand der freien Schenkel voneinander zu den Schenkelspitzen hin vergrößert und die Schenkel zueinander schräg gestellt sind.

Nach einem weiteren Merkmal der Erfindung ist der Profilsteg der U-förmigen Kühlrippe von teilkreisförmigem Querschnitt, der gegebenenfalls in Abstand zu den benachbarten Schenkelenden verläuft. Dabei soll der Scheitel des teilkreisförmigen Profilstegs zum Rippeninnenraum hin gerichtet sein.

Die Kühlrippen der beschriebenen Form sind bevorzugt stranggepreßt; die erwähnte Ausführung aus gerolltem Blech enthält erfindungsgemäß einen Profilsteg dreiecksförmigen Querschnittes, dessen Spitze in den Rippeninnenraum gerichtet ist.

Die geschilderten Ausführungen des Profilsteges mit zum Profilinnenraum hin aufragendem Zenit oder Scheitel verbessert das Festlegen der Kühlrippe in der ihr zugewiesenen Längsnut; der Profilsteg wird nach dem Einsetzen der Kühlrippe -- deren Rippenfuß dafür von geringerer Breite ist als der engste Bereich der Nutenbreite -- durch Druck so verformt, daß jener Scheitel abgesenkt wird und eine ebene Form des Profilsteges entsteht. Dabei werden die benachbarten Schenkelbereiche, also der Rippenfuß, nach außen -- und damit gegen die Nutenwände -- gedrückt; da die Querschnittsform der Längsnut eine Hinterschneidung anbietet, breitet sich der Rippenfuß also vor allem in die Hinterschneidung aus.

So hat sich also das Merkmal als günstig erwiesen, daß der Profilsteg in Benutzungsstellung der mit der Grundplatte verbundenen Kühlrippe querschnittlich eine Gerade bildet und der benachbarte Schenkelbereich oder Rippenfuß an hinterschnittene Abschnitten des Nutenquerschnitts angeschmiegt ist.

Dieses Ausformungsverfahren wird noch durch das Merkmal unterstützt, daß der Nutenboden von den Nutenwänden aus konkav gebogen ist, was erst die Planheit des verformten Profilsteges ermöglicht.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- Fig. 1:: die Frontansicht eines Kühlkörpers mit Kühlrippen an einer Grundplatte;
- Fig. 2:: einen vergrößerten Ausschnitt aus Fig. 1;
- Fig. 3 bis Fig. 5:: verschiedene Ausführungen von Kühlrippenabschnitten;
- Fig. 6:: eine einzelne Kühlrippe in Schrägsicht;
- Fig. 7:: einen vergrößerten Ausschnitt gemäß Fig. 2 zu einer weiteren Ausgestaltung.

Ein Kühlkörper 10 aus Leichtmetall -- insbesondere aus AlMgSiO.5 F 22 -- für in der Zeichnung aus Gründen der Übersichtlichkeit nicht weiter dargestellte Halbleiterbauelemente weist eine stranggepreßte Grundplatte 12 mit -- rinnenartige Profilierungen ergebenden -- Längsnuten 14 auf; diese sind durch Bodenrippen 16 voneinander getrennt, wobei die Nutenwände 18 in einem Winkel w von 1 bis 2° hinterschnitten sind. Hierdurch ergeben sich gegenläufig trapezartige Querschnitte von Längsnut 14 und Bodenrippe 16.

In die Längsnuten 14 der Nuttiefe a sind Kühlrippen 20, 20ₐ etwa U-förmigen Querschnitts eingesetzt, die entweder stranggepreßt oder aus rollgeformtem Band hergestellt sind. Ihre Schenkel 22 sind vor dem Einsetzen schräg nach außen gestellt und begrenzen so einen sich zu Schenkelspitzen 24 hin erweiternden Querschnitt; in Einbaustellung werden die Schenkel 22 von den Nutenwänden 18 in jenem Winkel w zueinander gedrückt.

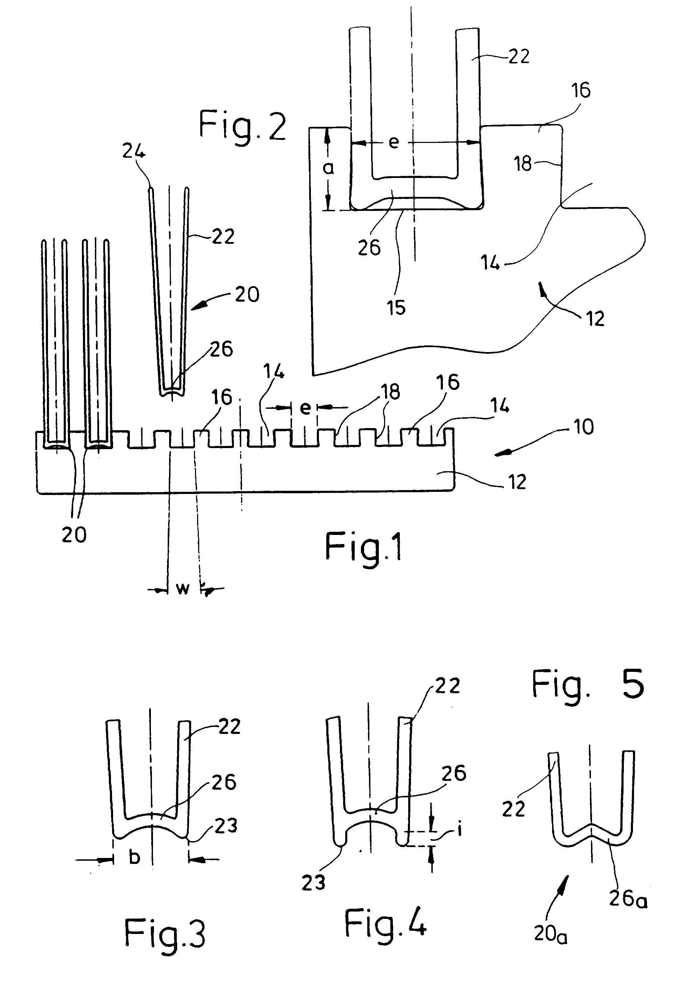

Der Profilsteg 26 der stranggepreßten Kühlrippe 20 ist querschnittlich teilkreisförmig gestaltet und gemäß Fig. 3 an den plattenwärtigen Schenkelenden 23 -- oder nach Fig. 4 in Abstand i zu diesen -- angeformt. Der Abstand i entspricht der halben Nuttiefe a.

In Fig. 2 ist der Profilsteg 26 nur in den Schenkelbereichen gebogen.

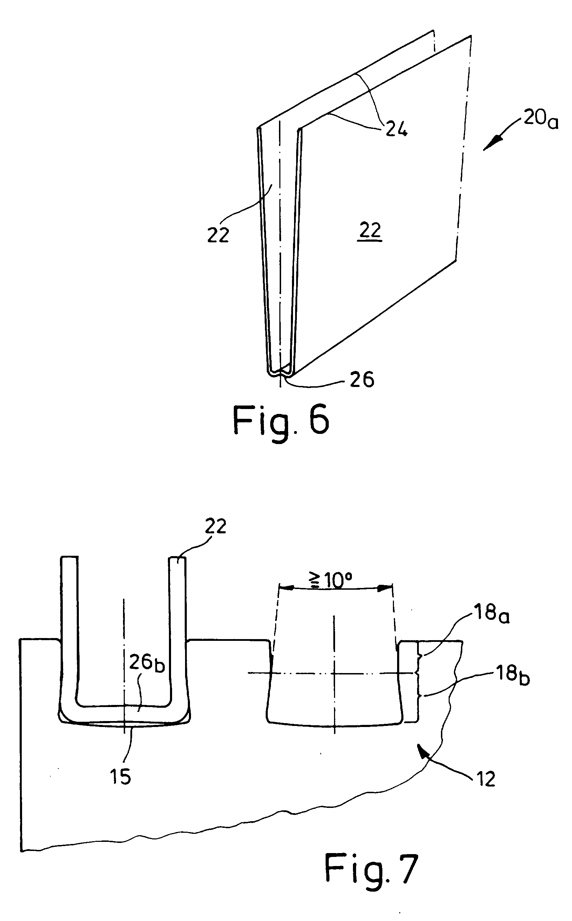

Der Profilsteg 26ₐ der Kühlrippe 20ₐ aus rollgeformtem Band ist in Fig. 5, 6 etwa dreiecksförmig gestaltet.

Fig. 7 läßt eine besondere Form der Längsnut 14ₐ erkennen; sie hat etwa zur Hälfte einen Rechteckquerschnitt (Abschnitt 18ₐ) , welcher ab halber Nutentiefe a zum Nutboden 15 hin sich schwalbenschwanzförmig erweitert (Abschnitt 18_{b}). Der Nutboden 15 ist hier konkav ausgeführt, der Profilsteg 26_{b} der festliegenden Kühlrippe 20ₐ bildet nach seiner unten erörterten Verformung eine Ebene.

Die Breite b des Rippenfußes ist kleiner als das Kleinstmaß der Nutenbreite e, so daß die Kühlrippen 20 zunächst ohne Kraftaufwand eingelegt werden können. Die Kühlrippe 20 wird in der Grundplatte 12 auf folgende Weise befestigt: Die kreisringsegmentförmigen bzw. dreieckförmigen Profilstege 26, 26ₐ werden mit einer Druckkraft, die sowohl mittels Rollen als auch durch Stemmwerkzeuge aufgebracht werden kann, so verformt, daß sie annähernd -- wie in Fig. 7 beschrieben -- eine Gerade bilden. Hierdurch werden die Schenkel 22 im Fußbereich gespreizt und gegen die Nutenwände 18 gepreßt, so daß zwischen Schenkelaußenseite und Nutenwand 18 eine formschlüssige Verbindung entsteht. Der hierbei erreichte Kontaktdruck gewährleistet für die vorgesehenen Anwendungsgebiete einen völlig ausreichenden Wärmeübergang.

## Patentansprüche

1. Kühlkörper für Halbleiterbauelemente od.dgl. Geräte, insbesondere zumindest teilweise aus stranggepreßtem Aluminium oder anderem Leichtmetall hergestellte Hochleistungskühleinheit mit in Abstand zueinander an einer Grundplatte angeschlossenen und davon aufragenden Kühlrippen, die jeweils als hohles Profil mit zwei seitlichen Rippenwänden ausgebildet sind, wobei die Kühlrippe in einer Längs- oder Einsatznut od.dgl. Ausnehmung der Grundplatte festliegt,
dadurch gekennzeichnet,
daß die Kühlrippe (20, 20ₐ) querschnittlich als U-Profil stranggepreßt oder aus einem rollgeformten Band hergestellt ist, wobei die als freie Schenkel (22) ausgebildeten Rippenwände in den Längsnuten (14) der Grundplatte (12) unter Bildung einer Rückstellkraft klemmend gehalten sind.

2. Kühlkörper nach Anspruch 1, dadurch gekennzeichnet, daß sich die Längsnuten (14) der Grundplatte (12) querschnittlich zum Nutengrund (15) hin wenigstens teilweise verjüngen.

3. Kühlkörper nach Anspruch 1, dadurch gekennzeichnet, daß sich der Abstand der freien Schenkel (22) voneinander zu den Schenkelspitzen (24) hin vergrößert und die Schenkel zueinander schräg gestellt sind.

4. Kühlkörper nach einem der Ansprüche 1 bis 3, dadurch gekennzeichnet, daß der Profilsteg (26) der U-förmigen Kühlrippe (20) von teilkreisförmigem Querschnitt ist.

5. Kühlkörper nach Anspruch 4, dadurch gekennzeichnet, daß der Profilsteg (26) in Abstand (i) zu den benachbarten Schenkelenden (23) verläuft.

6. Kühlkörper nach Anspruch 4 oder 5, dadurch gekennzeichnet, daß der Scheitel des teilkreisförmigen Profilstegs (26) zum Rippeninnenraum gerichtet ist.

7. Kühlkörper nach einem der Ansprüche 1 bis 3, dadurch gekennzeichnet, daß der Profilsteg (26ₐ) der U-förmigen Kühlrippe (20ₐ) einen dreiecksförmigen Querschnitt aufweist, dessen Spitze in den Rippeninnenraum gerichtet ist.

8. Kühlkörper nach einem der Ansprüche 1 bis 7, dadurch gekennzeichnet, daß der Nutenboden (15) von den Nutenwänden (18) aus konkav gebogen ist.

9. Kühlkörper nach wenigstens einem der Ansprüche 1 bis 8, dadurch gekennzeichnet, daß die Breite (b) des Rippenfußes kleiner ist als der engste Bereich der Nutenbreite (e).

10. Kühlkörper nach Anspruch 6 oder 7, dadurch gekennzeichnet, daß der Profilsteg (26, 26ₐ) in Benutzungsstellung der mit der Grundplatte (12) verbundenen Kühlrippe (20, 20ₐ) querschnittlich eine Gerade bildet und der benachbarte Schenkelbereich oder Rippenfuß an hinterschnittenen Abschnitten (18_{b}) des Nutenquerschnitts angeschmiegt ist.
